# EUROPÄISCHE PATENTSCHRIFT

(11) **EP 3 292 441 B1**
(45) Veröffentlichungstag und Bekanntmachung des Hinweises auf die Patenterteilung: **27.02.2019**
(21) Anmeldenummer: 16718368.0
(22) Anmeldetag: 26.04.2016
(51) Int. Cl.: G03F 7/20, G02B 26/08, G02B 5/08, G02B 5/09

(54) **FACETTENSPIEGEL FÜR DIE EUV-PROJEKTIONSLITHOGRAPHIE SOWIE BELEUCHTUNGSOPTIK MIT EINEM DERARTIGEN FACETTENSPIEGEL**
FACETED MIRROR FOR EUV PROJECTION LITHOGRAPHY AND ILLUMINATION OPTICAL UNIT COMPRISING SUCH A FACETED MIRROR
MIROIR À FACETTES POUR LA LITHOGRAPHIE PAR PROJECTION À RAYONS ULTRAVIOLETS PROFONDS ET DISPOSITIF OPTIQUE D'ILLUMINATION COMPRENANT UN MIROIR À FACETTES DE CE TYPE

(30) Priorität: 07.05.2015 DE 102015208514
(43) Veröffentlichungstag der Anmeldung: 14.03.2018
(73) Patentinhaber: Carl Zeiss SMT GmbH, 73447 Oberkochen (DE)
(72) Erfinder: FISCHER, Thomas, 73430 Aalen (DE); WUNDERLICH, Sarina, 73431 Aalen (DE)
(74) Vertreter: Rau, Schneck & Hübner Patentanwälte Rechtsanwälte PartGmbB
(86) Internationale Anmeldenummer: PCT/EP2016/059219
(87) Internationale Veröffentlichungsnummer: WO 2016/177599

(56) Entgegenhaltungen:
- DE-A1-102008 009 600
- DE-A1-102008 040 938
- DE-A1-102012 220 597
- US-A1- 2010 053 584

## Beschreibung

Die vorliegende Patentanmeldung nimmt die Priorität der deutschen Patentanmeldung DE 10 2015 208 514.7 in Anspruch, deren Inhalt durch Bezugnahme hierin aufgenommen wird.

Die Erfindung betrifft einen Facettenspiegel für die EUV-Projektionslithografie. Ferner betrifft die Erfindung eine Beleuchtungsoptik mit einem derartigen Facettenspiegel, ein Beleuchtungssystem und ein optisches System mit einer derartigen Beleuchtungsoptik, eine Projektionsbelichtungsanlage mit einem derartigen optischen System, ein Verfahren zur Herstellung eines mikro- bzw. nanostrukturierten Bauteils mithilfe einer derartigen Projektionsbelichtungsanlage.

Eine Beleuchtungsoptik der eingangs genannten Art ist bekannt aus der US 2011/0001947 A1, der WO 2009/132 756 A1, der WO 2009/100 856 A1 sowie aus der US 6 438 199 B1 und der US 6 658 084 B2. Ein Feldfacettenspiegel ist bekannt aus der DE 19 931 848 A1, aus der WO 2008/149 178 A1, aus der DE 10 2011 076 145 A1 und aus der US 6,859,328. Die US 2010/0053584A1 beschreibt eine Projektionsbelichtungsanlage mit einer Beleuchtungsoptik mit facettierten Spiegeln. Die DE 10 2012 220 597 A1 beschreibt eine Beleuchtungsoptik für die EUV-Projektionslithografie mit zwei Facettenspiegeln. Die DE 10 2008 040 938 A1 beschreibt ein Verfahren zur Erzeugung optischer Flächen von Feldfacetten für facettierte optische Komponenten. Die DE 10 2008 009 600 A1 beschreibt einen Facettenspiegel zum Einsatz in einer Projektionsbelichtungsanlage für die Mikro-Lithografie.

Es ist eine Aufgabe der vorliegenden Erfindung, einen Facettenspiegel der eingangs genannten Art derart weiterzubilden, dass dessen EUV-Durchsatz insbesondere bei einem längeren Betrieb einer hiermit ausgerüsteten Projektionsbelichtungsanlage erhöht ist.

Diese Aufgabe ist erfindungsgemäß gelöst durch einen Facettenspiegel mit den im Anspruch 1 angegebenen Merkmalen. Die angegebene Flächenform wird nachfolgend auch als "torische Fläche" bezeichnet. Krümmungsradien einer solchen "torischen Fläche" müssen nicht so unterschiedlich sein, dass sich insgesamt ein Torus ergibt, müssen sich also nicht um mehr als einen Faktor 2 unterscheiden.

Erfindungsgemäß wurde erkannt, dass eine Verkippung von Krümmungsachsen, die die Krümmungen einer Flächenform der Facetten-Reflexionsfläche definieren, zu Ausrichtungskoordinaten dieser Facetten einen zusätzlichen Freiheitsgrad liefert, der zur Optimierung einer Führung von Beleuchtungslicht-Teilbündeln über durch die jeweiligen Feldfacetten definierte Ausleuchtungskanäle verbessert. Insbesondere kann ein feldabhängiger Schwerpunktverlauf von Beleuchtungslicht-Subbündeln, die von unterschiedlichen Punkten auf der Facette ausgehen, auf Facetten eines nachgeordneten Facettenspiegels gezielt so beeinflusst werden, dass das Beleuchtungslicht-Subbündel dort, wo es von nachfolgenden Komponenten der Beleuchtungsoptik und insbesondere von den Facetten des nachgeordneten Facettenspiegels geführt ist, vorteilhaft und nach Möglichkeit feldunabhängig kompakt verläuft. Eine Verkippung der Krümmungsachsen gegenüber den Ausrichtungskoordinaten x, y der Facetten-Gesamtanordnung kann um eine z-Koordinate der Facetten-Gesamtanordnung erfolgen. Beide Krümmungsachsen der torischen Fläche können um die gleiche Achse verkippt sein. Die Krümmungsradien der torischen Fläche um die beiden Krümmungsachsen sind unterschiedlich. Die Krümmungsradien können im Bereich zwischen 200 mm und 2000 mm, insbesondere im Bereich zwischen 500 mm und 1500 mm oder zwischen 800 mm und 1200 mm und insbesondere im Bereich um 1000 mm liegen. Eine Exzentrizität, also ein Unterschied zwischen den beiden Krümmungsradien kann im Bereich zwischen 10 mm und 100 mm und besonders im Bereich zwischen 20 mm und 60 mm, beispielsweise im Bereich um 40 mm liegen. Jedenfalls der jeweils kleinere Krümmungsradius der torischen Reflexionsfläche der jeweiligen Ausricht-Facette ist endlich. Soweit es sich bei den verkippten Krümmungsachsen der Reflexionsfläche der mindestens einen Ausricht-Facette um Hauptkrümmungsachsen der Reflexionsfläche handelt, die stets zueinander orthogonal verlaufen, genügt die Angabe eines einzigen Achsen-Kippwinkels der Krümmungsachsen relativ zu den Ausrichtungskoordinaten zur Spezifizierung einer Reflexionsflächenverkippung.

Unter einer torischen Fläche im Sinne dieser Anmeldung wird eine Flächenform verstanden, die unterschiedliche Krümmungen längs zweier Krümmungsachsen aufweist, bei denen es sich um zwei aufeinander senkrecht stehende Hauptkrümmungsachsen handeln kann. Die zugehörigen Krümmungen können sphärisch oder asphärisch ausgeführt sein und sich beispielsweise durch eine Entwicklung von zueinander orthogonalen Basisfunktionen beschreiben lassen. Auch eine Ellipsoid-Fläche mit unterschiedlichen Krümmungen längst mindestens zweier Krümmungsachsen stellt in diesem Sinne eine torische Fläche dar.

Alle Facetten des Facettenspiegels können als derartige Ausricht-Facetten mit zu den Ausrichtungskoordinaten verkippten, die torische Flächen jeweils definierenden Krümmungsachsen ausgeführt sein.

Bei einer Ausgestaltung nach Anspruch 2 wird eine Verkippung der Krümmungsachsen der torischen Reflexionsfläche der jeweiligen Facette relativ zu den Ausrichtungskoordinaten der Facetten-Gesamtanordnung für mindestens zwei der Ausricht-Facetten individuell vorgegeben. Hierdurch ergibt sich ein weiterer Freiheitsgrad zur Optimierung einer Bündelführung der EUV-Beleuchtungslicht-Teilbündel über die torischen Facetten-Reflexionsflächen.

Ein Achsen-Kippwinkel nach Anspruch 3 hat sich zur Optimierung als besonders geeignet herausgestellt. Der Achsen-Kippwinkel kann mindestens 2 Grad betragen, kann mindestens 3 Grad betragen, kann mindestens 4 Grad betragen, kann mindestens 5 Grad betragen und kann beispielsweise 6 Grad betragen. Auch ein noch größerer Achsen-Kippwinkel ist möglich, zum Beispiel ein Achsen-Kippwinkel von 10 Grad, von 15 Grad oder ein noch größerer Achsen-Kippwinkel.

Ein unendlicher größerer Krümmungsradius nach Anspruch 4 führt zu einer torischen Reflexionsfläche in Form einer Zylinderlinse. In diesem Fall gibt es letztlich genau eine Krümmungsachse, die die Form der Zylinderlinse definiert, da es wegen der unendlichen Krümmung auf eine Richtung der anderen Krümmungsachse nicht ankommt. Auch bei einer solchen Spezialfall-Gestaltung der mindestens einen Ausricht-Facette als Zylinderlinse folgt eine entsprechende Verkippung der Zylinder-Krümmungsachse gegenüber der Ausrichtungskoordinate der Facetten-Gesamtanordnung.

Zwei endliche Krümmungsradien nach Anspruch 5 führen zu einer über zwei Krümmungsachsen gekrümmten Reflexionsfläche.

Die Vorteile einer Beleuchtungsoptik nach Anspruch 6 entsprechen denen, die vorstehend unter Bezugnahme auf den Facettenspiegel bereits erläutert wurden.

Bei dem Facettenspiegel mit der mindestens einer Ausrichtungs-Facette kann es sich um einen Feldfacettenspiegel der Beleuchtungsoptik handeln.

Einige oder alle der Feldfacetten und/oder der Pupillenfacetten können ihrerseits aus einer Mehrzahl von Einzelspiegelchen aufgebaut sein. Insbesondere kann der Feldfacettenspiegel und/oder der Pupillenfacettenspiegel als MEMS (mikro-elektromechanischer Spiegel)-Array aufgebaut sein, wobei jede der Feldfacetten bzw. jede der Pupillenfacetten dann aus einer Mehrzahl von MEMS-Spiegelchen aufgebaut sein kann. Ein Beispiel für einen solchen MEMS-Aufbau liefert die WO 2009/100 856 A1.

Die im jeweiligen Ausleuchtungskanal der Feldfacetten nachgeordnete Übertragungsoptik kann ausschließlich durch eine innerhalb eines Ausleuchtungskanals jeweils nachgeordnete Pupillenfacette gebildet sein. Alternativ kann die Übertragungsoptik auch noch weitere Komponenten, insbesondere weitere Spiegel aufweisen, die z. B. einer Pupillenfacette eines jeweiligen Ausleuchtungskanals noch nachgeordnet und dem Objektfeld vorgeordnet sind.

Die Vorteile eines Beleuchtungssystems nach Anspruch 7, eines optischen Systems nach Anspruch 8, einer Projektionsbelichtungsanlage nach Anspruch 9, eines Herstellungsverfahrens nach Anspruch 10 und eines hiermit hergestellten mikro- bzw. nanostrukturierten Bauteils entsprechen denen, die vorstehend unter Bezugnahme auf die erfindungsgemäße Beleuchtungsoptik bereits erläutert wurden.

Das Bauteil kann mit extrem hoher Strukturauflösung hergestellt sein. Auf diese Weise kann beispielsweise ein Halbleiterchip mit extrem hoher Integrations- bzw. Speicherdichte hergestellt werden.

Ausführungsbeispiele der Erfindung werden nachfolgend anhand der Zeichnung näher erläutert. Es zeigen:
- Fig. 1: schematisch einen Meridionalschnitt durch eine Projektionsbelichtungsanlage für die EUV-Projektionslithografie;
- Fig. 2 und 3: Anordnungsvarianten von Feldfacettenspiegeln, die mit monolithischen Feldfacetten ausgeführt sein können, aber auch Feldfacetten aufweisen können, die jeweils aus einer Mehrzahl von Einzelspiegeln aufgebaut sind;
- Fig. 4: schematisch eine Aufsicht auf einen Pupillenfacettenspiegel, der gemeinsam mit dem Feldfacettenspiegel Teil einer Beleuchtungsoptik der Projektionsbelichtungsanlage ist:

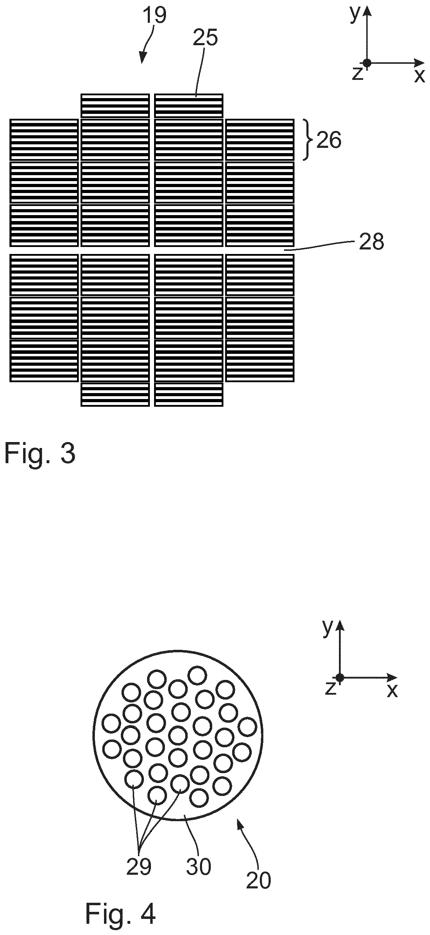

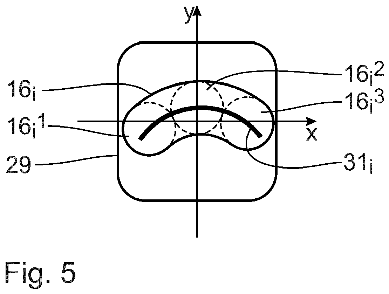

- Fig. 5: eine Variante einer Pupillenfacette, die beim Pupillenfacettenspiegel nach Fig. 4 zum Einsatz kommen kann, wobei auf der Pupillenfacette eine Randkontur eines BeleuchtungslichtTeilbündels dargestellt ist, mit dem die Pupillenfacette über genau eine der Feldfacetten und einen vorgegebenen Ausleuchtungskanal beaufschlagt ist, wobei zusätzlich zur Randkontur des Beleuchtungslicht-Teilbündels auch ein feldabhängiger Schwerpunktverlauf von BeleuchtungslichtSubbündeln dargestellt ist, die von unterschiedlichen Punkten auf der zugehörigen Feldfacette bei der Abbildung der Lichtquelle ausgehen;
- Fig. 6: eine Aufsicht auf zwei benachbarte Feldfacetten innerhalb einer Feldfacetten-Anordnung entsprechend Fig. 3;
- Fig. 7: einen Schnitt durch eine der beiden Feldfacetten nach Fig. 6 gemäß Linie VII-VII in Fig. 6;
- Fig. 8: ein Schnitt durch die Feldfacette gemäß Linie VIII-VIII in Fig. 6;
- Fig. 9: eine zu Fig. 5 ähnliche Darstellung einer weiteren Variante einer Pupillenfacette, wobei der feldabhängige Schwerpunktverlauf der von unterschiedlichen Punkten auf der Feldfacette ausgehenden Beleuchtungslicht-Subbündel bei der Abbildung der Lichtquelle für einen Ausleuchtungskanal dargestellt ist, der über die gleiche Pupillenfacette geführt wird, wobei die Abbildung einerseits mit einer konventionellen Feldfacette und andererseits mit einer erfindungsgemäß torisch gestalteten und verkippten Feldfacetten-Reflexionsfläche geschieht;
- Fig. 10: in einer zu Fig. 9 ähnlichen Darstellung die feldabhängigen Schwerpunktverläufe der von unterschiedlichen Punkten auf der Feldfacette ausgehenden Beleuchtungslicht-Subbündel für einen Ausleuchtungskanal geführt über eine weitere Pupillenfacette, wobei die Abbildung wiederum einerseits mit einer konventionellen Feldfacette und andererseits mit einer erfindungsgemäß torisch gestalteten und verkippten Feldfacetten-Reflexionsfläche geschieht.

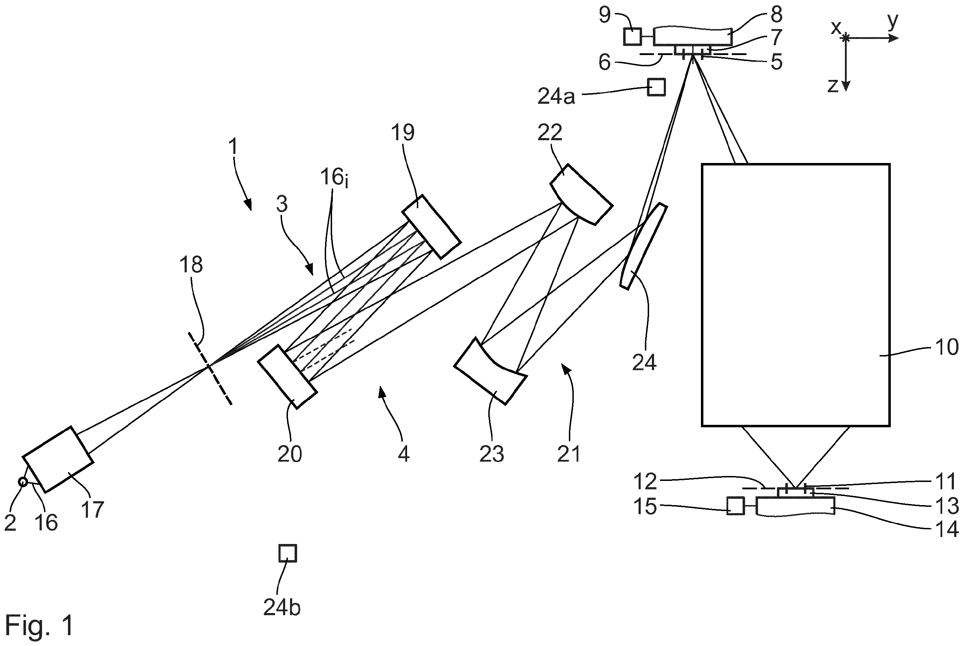

Fig. 1 zeigt schematisch in einem Meridionalschnitt eine Projektionsbelichtungsanlage 1 für die Mikro-Lithografie. Zur Projektionsbelichtungsanlage 1 gehört eine Licht- bzw. Strahlungsquelle 2. Ein Beleuchtungssystem 3 der Projektionsbelichtungsanlage 1 hat eine Beleuchtungsoptik 4 zur Belichtung eines mit einem Objektfeld 5 zusammenfallenden Beleuchtungsfeldes in einer Objektebene 6. Das Beleuchtungsfeld kann auch größer sein als das Objektfeld 5. Belichtet wird hierbei ein Objekt in Form eines im Objektfeld 5 angeordneten Retikels 7, das von einem Objekt- bzw. Retikelhalter 8 gehalten ist. Das Retikel 7 wird auch als Lithographiemaske bezeichnet. Der Objekthalter 8 ist über einen Objektverlagerungsantrieb 9 längs einer Objekt-Verlagerungsrichtung verlagerbar. Eine stark schematisch dargestellte Projektionsoptik 10 dient zur Abbildung des Objektfeldes 5 in ein Bildfeld 11 in einer Bildebene 12. Abgebildet wird eine Struktur auf dem Retikel 7 auf eine lichtempfindliche Schicht eines im Bereich des Bildfeldes 11 in der Bildebene 12 angeordneten Wafers 13. Der Wafer 13 wird von einem Waferhalter 14 gehalten. Der Waferhalter 14 ist über einen Waferverlagerungsantrieb 15 synchronisiert zum Objekthalter 8 parallel zur Objekt-Verlagerungsrichtung verlagerbar.

Bei der Strahlungsquelle 2 handelt es sich um eine EUV-Strahlungsquelle mit einer emittierten Nutzstrahlung im Bereich zwischen 5 nm und 30 nm. Es kann sich dabei um eine Plasmaquelle, beispielsweise um eine GDPP-Quelle (Plasmaerzeugung durch Gasentladung, gasdischarge-produced plasma) oder um eine LPP-Quelle (Plasmaerzeugung durch Laser, laserproduced plasma) handeln. Auch eine Strahlungsquelle, die auf einem Synchrotron oder auf einem freien Elektronenlaser (FEL) basiert, ist für die Strahlungsquelle 2 einsetzbar. Informationen zu einer derartigen Strahlungsquelle findet der Fachmann beispielsweise aus der US 6,859,515 B2. EUV-Strahlung 16, die von der Strahlungsquelle 2 ausgeht, insbesondere das das Objektfeld 5 beleuchtende Nutz-Beleuchtungslicht, wird von einem Kollektor 17 gebündelt. Ein entsprechender Kollektor ist aus der EP 1 225 481 A bekannt. Nach dem Kollektor 17 propagiert die EUV-Strahlung 16 durch eine Zwischenfokusebene 18, bevor sie auf einen Feldfacettenspiegel 19 trifft. Der Feldfacettenspiegel 19 ist ein erster Facettenspiegel der Beleuchtungsoptik 4. Der Feldfacettenspiegel 19 hat eine Mehrzahl von reflektierenden Feldfacetten, die in der Fig. 1 nicht dargestellt sind. Der Feldfacettenspiegel 19 ist in einer Feldebene der Beleuchtungsoptik 4 angeordnet, die zur Objektebene 6 optisch konjugiert ist.

Die EUV-Strahlung 16 wird nachfolgend auch als Beleuchtungslicht oder als Abbildungslicht bezeichnet.

Nach dem Feldfacettenspiegel 19 wird die EUV-Strahlung 16 von einem Pupillenfacettenspiegel 20 reflektiert. Der Pupillenfacettenspiegel 20 ist ein zweiter Facettenspiegel der Beleuchtungsoptik 4. Der Pupillenfacettenspiegel 20 ist in einer Pupillenebene der Beleuchtungsoptik 4 angeordnet, die zur Zwischenfokusebene 18 und zu einer Pupillenebene der Beleuchtungsoptik 4 und der Projektionsoptik 10 optisch konjugiert ist oder mit dieser Pupillenebene zusammenfällt. Der Pupillenfacettenspiegel 20 hat eine Mehrzahl von reflektierenden Pupillenfacetten, die in der Fig. 1 nicht dargestellt sind. Mit Hilfe der Pupillenfacetten des Pupillenfacettenspiegels 20 und einer nachfolgenden abbildenden optischen Baugruppe in Form einer Übertragungsoptik 21 mit in der Reihenfolge des Strahlengangs bezeichneten Spiegeln 22, 23 und 24 werden die Feldfacetten des Feldfacettenspiegels 19 einander überlagernd in das Objektfeld 5 abgebildet. Der letzte Spiegel 24 der Übertragungsoptik 21 ist ein Spiegel für streifenden Einfall ("Grazing Incidence-Spiegel"). Je nach Ausführung der Beleuchtungsoptik 4 kann auf die Übertragungsoptik 21 auch gänzlich oder teilweise verzichtet werden.

Beleuchtungslicht 16, welches beispielsweise in der Objektebene 6 hin zu größeren absoluten x-Werten als die x-Dimension des Objektfeldes 5 geführt wird, kann mithilfe einer entsprechenden, nicht dargestellten Optik hin zu mehreren Energie- bzw. Dosissensoren geführt werden, von denen in der Fig. 1 ein Dosissensor 24a schematisch dargestellt ist. Der Dosissensor 24a steht mit einer zentralen Steuereinrichtung 24b in nicht dargestellter Weise in Signalverbindung. Der Dosissensor 24a erzeugt ein Eingangssignal zur Steuerung der Lichtquelle 2 und/oder des Objektverlagerungsantriebs 9 und/oder des Waferverlagerungsantriebs 15. Hierüber kann eine Dosisanpassung einer Belichtung des Wafers 13 im Bildfeld 11 durch Anpassung einerseits einer Leistung der Lichtquelle 2 und/oder andererseits einer Scangeschwindigkeit erreicht werden.

Die Steuereinrichtung 24b steht unter anderem mit Kipp-Aktoren für die Feldfacetten 25 des Feldfacettenspiegels 19 in Signalverbindung.

Zur Erleichterung der Beschreibung von Lagebeziehungen ist in der Fig. 1 ein kartesisches xyz-Koordinatensystem als globales Koordinatensystem für die Beschreibung der Lageverhältnisse von Komponenten der Projektionsbelichtungsanlage 1 zwischen der Objektebene 6 und der Bildebene 12 eingezeichnet. Die x-Achse verläuft in der Fig. 1 senkrecht zur Zeichenebene in diese hinein. Die y-Achse verläuft in der Fig. 1 nach rechts und parallel zur Verlagerungsrichtung des Objekthalters 8 und des Waferhalters 14. Die z-Achse verläuft in der Fig. 1 nach unten, also senkrecht zur Objektebene 6 und zur Bildebene 12.

Die x-Dimension über das Objektfeld 5 bzw. das Bildfeld 11 wird auch als Feldhöhe bezeichnet. Die Objektverlagerungsrichtung verläuft parallel zur y-Achse.

In den weiteren Figuren sind lokale kartesische xyz-Koordinatensysteme eingezeichnet. Die x-Achsen der lokalen Koordinatensysteme verlaufen parallel zur x-Achse des globalen Koordinatensystems nach Fig. 1. Die xy-Ebenen der lokalen Koordinatensysteme stellen Anordnungsebenen der jeweils in der Figur dargestellten Komponente dar. Die y- und z-Achsen der lokalen Koordinatensysteme sind entsprechend um die jeweilige x-Achse um einen bestimmten Winkel verkippt.

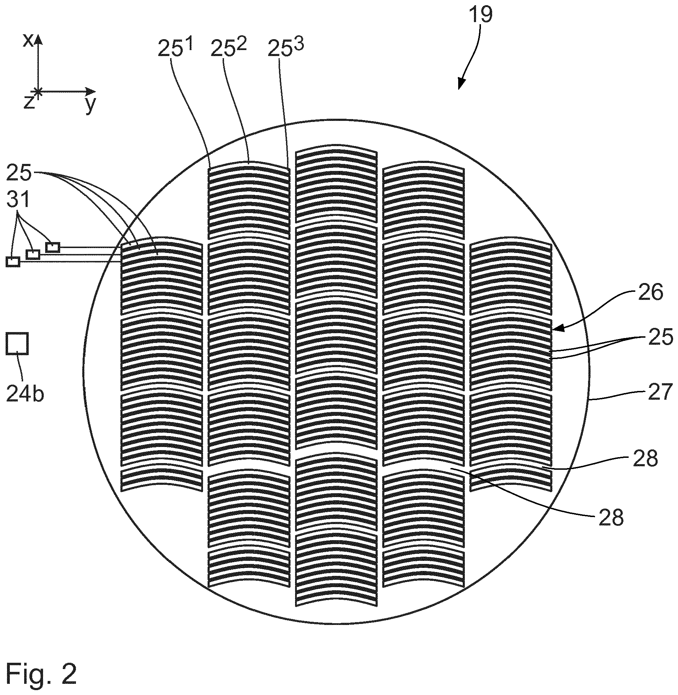

Die Fig. 2 und 3 zeigen Beispiele verschiedener Facettenanordnungen für den Feldfacettenspiegel 19. Jede der dort dargestellten Feldfacetten 25 kann als Einzelspiegel-Gruppe aus einer Mehrzahl von Einzelspiegeln aufgebaut sein, wie beispielsweise aus der WO 2009/100 856 A1 bekannt. Jeweils eine der Einzelspiegel-Gruppen hat dann die Funktion einer Facette eines Feldfacettenspiegels, wie dieser beispielsweise in der US 6,438,199 B1 oder der US 6,658,084 B2 offenbart ist.

Die Feldfacetten 25 können aktorisch zwischen einer Mehrzahl von Kippstellungen verkippbar ausgeführt sein.

Der Feldfacettenspiegel 19 nach Fig. 2 hat eine Vielzahl gebogen ausgeführter Feldfacetten 25. Diese sind gruppenweise in Feldfacetten-Blöcken 26 auf einem Feldfacetten-Träger 27 angeordnet. Insgesamt hat der Feldfacettenspiegel 19 nach Fig. 2 sechsundzwanzig Feldfacetten-Blöcke 26, zu denen drei, fünf oder zehn der Feldfacetten 25 gruppenweise zusammengefasst sind.

Zwischen den Feldfacetten-Blöcken 26 liegen Zwischenräume 28 vor.

Der Feldfacettenspiegel 19 nach Fig. 3 hat rechteckige Feldfacetten 25, die wiederum gruppenweise Feldfacetten-Blöcken 26 angeordnet sind, zwischen denen Zwischenräume 28 vorliegen.

Fig. 4 zeigt schematisch eine Aufsicht auf den Pupillenfacettenspiegel 20. Pupillenfacetten 29 des Pupillenfacettenspiegels 20 sind im Bereich einer Beleuchtungspupille der Beleuchtungsoptik 4 angeordnet. Die Anzahl der Pupillenfacetten 29 ist in der Realität größer als in Fig. 4 dargestellt. In der Realität kann die Anzahl der Pupillenfacetten 29 größer sein als die Anzahl der Feldfacetten 25 und kann ein Vielfaches der Anzahl der Feldfacetten 25 betragen. Die Pupillenfacetten 29 sind auf einem Pupillenfacetten-Träger des Pupillenfacettenspiegels 20 angeordnet. Eine Verteilung von über die Feldfacetten 25 mit dem Beleuchtungslicht 16 beaufschlagten Pupillenfacetten 29 innerhalb der Beleuchtungspupille gibt eine Ist-Beleuchtungswinkelverteilung im Objektfeld 5 vor.

Jede der Feldfacetten 25 dient zur Überführung eines Teils des Beleuchtungslichts 16, also eines Beleuchtungslicht-Teilbündel 16ᵢ, von der Lichtquelle 2 hin zu einer der Pupillenfacetten 29.

Nachfolgend wird bei einer Beschreibung von Beleuchtungslicht-Teilbündeln 16ᵢ davon ausgegangen, dass die zugehörige Feldfacette 25 jeweils maximal, also über ihre gesamte Reflexionsfläche, ausgeleuchtet ist. In diesem Fall fällt eine Randkontur des Beleuchtungslicht-Teilbündels 16ᵢ mit einer Randkontor des Ausleuchtungskanals zusammen, weswegen die Ausleuchtungskanäle nachfolgend auch mit 16ᵢ bezeichnet werden. Der jeweilige Ausleuchtungskanal 16ᵢ stellt einen möglichen Lichtweg eines die zugehörige Feldfacette 25 maximal ausleuchtenden Beleuchtungslicht-Teilbündels 16ᵢ über die weiteren Komponenten der Beleuchtungsoptik 4 dar.

Die Übertragungsoptik 21 weist für jeden der Ausleuchtungskanäle 16ᵢ jeweils eine der Pupillenfacetten 29 zur Überführung des Beleuchtungslicht-Teilbündels 16ᵢ von der Feldfacette 25 hin zum Objektfeld 5 auf.

Jeweils ein Beleuchtungslicht-Teilbündel 16ᵢ, von denen in der Fig. 1 schematisch zwei Beleuchtungslicht-Teilbündel 16ᵢ (i = 1,..., N; N: Anzahl der Feldfacetten) dargestellt sind, ist zwischen der Lichtquelle 2 und dem Objektfeld 5 über genau eine der Feldfacetten 25 und über genau eine der Pupillenfacetten 29 über jeweils einen Ausleuchtungskanal geführt.

Fig. 5 zeigt eine der Pupillenfacetten 29, die beim Pupillenfacettenspiegel 20 zum Einsatz kommen kann. Die Pupillenfacette 29 nach Fig. 5 hat keine kreisrunde Randkontur, wie in der Fig. 4 dargestellt, sondern eine annähernd quadratische Randkontur mit abgerundeten Ecken. Eine solche Randkontur, die auch ohne abgerundete Ecken, also quadratisch oder rechteckig gestaltet sein kann, ermöglicht es, den Pupillenfacetten-Träger 30 relativ dicht mit den Pupillenfacetten 29 zu belegen.

Die Pupillenfacette 29 nach Fig. 5 wird von einer bogenförmigen Feldfacette 25 des Feldfacettenspiegels 19 nach Fig. 2 mit dem Beleuchtungslicht-Teilbündel 16ᵢ beaufschlagt.

Bei der in der Fig. 5 dargestellten Anordnung liegt ein gesamter Querschnitt des Beleuchtungslicht-Teilbündels 16ᵢ auf der Pupillenfacette 29, so dass das Beleuchtungs-Teilbündel 16ᵢ randseitig nicht vom Rand der Pupillenfacette 29 beschnitten ist. Eine Randkontur des Querschnitts des Beleuchtungslicht-Teilbündels 16ᵢ auf der Pupillenfacette 29 hat eine angenähert bogen-, bohnen- oder nierenförmige Form und kann verstanden werden als Faltung der bogenförmigen Feldfacetten 25 nach Fig. 2 mit einer runden Quellfläche der Lichtquelle 2. Diese Faltung entsteht aufgrund der Tatsache, dass ein Bild der Lichtquelle 2 für verschiedene Abschnitte auf der zugehörigen Feldfacette 25, also feldabhängig, an unterschiedlichen Bildorten und zudem im Regelfall an einem Bildort entsteht, der längs des Ausleuchtungskanals 16ᵢ beabstandet zur Pupillenfacette 29, im Strahlengang also entweder vor oder nach der Pupillenfacette 29, liegt.

Die bogenförmige Randkontur des Beleuchtungslicht-Teilbündels 16ᵢ auf der Pupillenfacette 29 stellt einen Lichtfleck des Beleuchtungslicht-Teilbündels 16ᵢ dar.

Gestrichelt sind in die Randkontur des Beleuchtungslicht-Teilbündels 16ᵢ auf der Pupillenfacette 29 drei Subbündel 16ᵢ¹, 16ᵢ² und 16ᵢ³ eingezeichnet. Das Beleuchtungslicht-Teilbündel 16ᵢ setzt sich aus einer Vielzahl derartiger Subbündel 16ᵢ^{j} zusammen. Das Beleuchtungslicht-Teilbündel 16ᵢ auf der jeweiligen Pupillenfacette 29 kann, sofern die optischen Parameter der Beleuchtung bekannt sind, beispielsweise mit Hilfe eines optischen Designprogramms, berechnet werden und wird in diesem Zusammenhang auch als "Point-Spread-Function" (Punktausbreitungsfunktion) bezeichnet.

Das Beleuchtungslicht 16 dieser Subbündel 16ᵢ¹ bis 16ᵢ³ geht aus von einem linken Randpunkt 25¹, von einem zentralen Punkt 25² und von einem rechten Randpunkt 25³ der zugehörigen Feldfacette 25. In der Fig. 2 sind beispielhaft diese Ausgangspunkte 25¹ bis 25³ auf einer der Feldfacetten 25 eingezeichnet.

Einen Kern einer Randkontur des jeweiligen Beleuchtungslicht-Teilbündels 16ᵢ auf jeder Pupillenfacette 29 stellt ein feldabhängiger Schwerpunktverlauf 31ᵢ aller von der zugehörigen Feldfacette 25 ausgehenden Subbündel 16ᵢ^{j} dar. Dieser Schwerpunktverlauf 31ᵢ ist individuell für jeden Ausleuchtungskanal 16ᵢ und hängt ab unter anderem vom geometrischen Verlauf des Ausleuchtungskanals 16ᵢ zwischen der Lichtquelle 2 und der jeweiligen Pupillenfacette 29 über die zugehörige Feldfacette 25.

Fig. 5 zeigt hierbei einen idealisierten feldabhängigen Schwerpunktverlauf 31ᵢ.

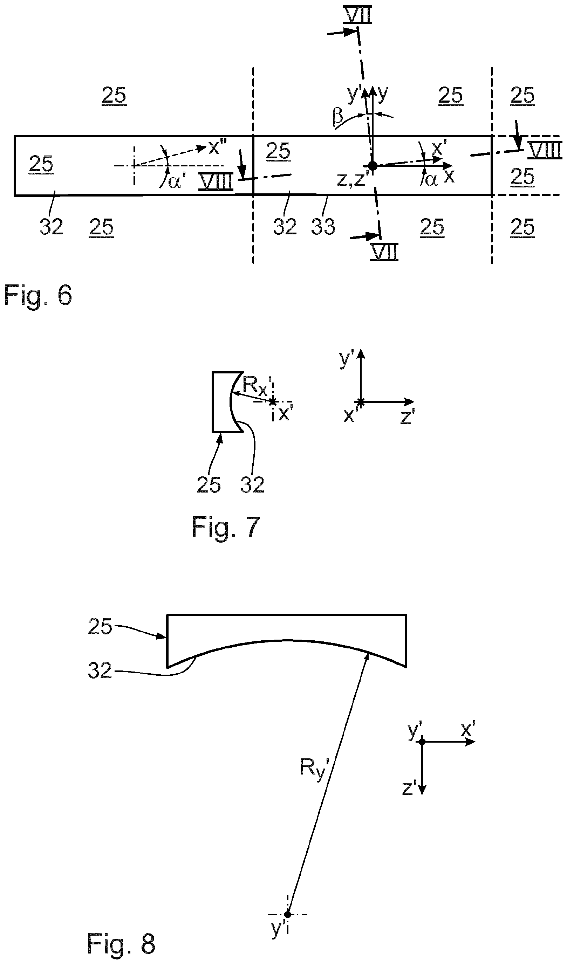

Zur Beeinflussung einer Ausdehnung einer Randkontur des Beleuchtungslicht-Teilbündels 13ᵢ bzw. einer xy-Ausdehnung des jeweiligen feldabhängigen Schwerpunktverlaufes 31ᵢ sind Reflexionsflächen 32 der Feldfacetten 25 als torische Flächen ausgebildet. Dies wird nachfolgend anhand der Fig. 6 bis 8 am Beispiel rechteckiger Feldfacetten 25 nach Art derjenigen der Fig. 3 erläutert.

Eine rechteckige Randkontur 33 der Feldfacetten 25 ist längs zweier Ausrichtungskoordinaten x und y einer beispielsweise in der Fig. 3 dargestellten Facetten-Gesamtanordnung ausgerichtet. Die x-Koordinate dieser ausgerichteten Randkontur 33 fällt also mit der x-Koordinate der Facetten-Gesamtanordnung zusammen. Entsprechendes gilt für die y-Koordinate.

Die Facetten, für die diese Ausrichtung gilt, werden nachfolgend auch als Ausricht-Facetten 25 bezeichnet. Zu den Krümmungsachsen x', y' der torischen Reflexionsflächen dieser Ausricht-Facetten 25 sind gegenüber den Ausrichtungskoordinaten x, y der Facetten-Gesamtanordnung jeweils um einen endlichen Achsen-Kippwinkel verkippt.

Die Krümmungsachse x' ist dabei relativ zur Ausrichtungskoordinate x um einen Achsen-Kippwinkel α um die Ausrichtungskoordinate z verkippt. Die Krümmungsachse y' ist um den Achsen-Kippwinkel β relativ zur Ausrichtungskoordinate y wiederum um die Ausrichtungskoordinate z verkippt. Da es sich bei den Koordinaten der Krümmungsachsen x', y' wie auch bei den Ausrichtungskoordinaten xyz um kartesische Koordinaten handelt, sind in diesem Fall die beiden Winkel α und β gleich groß.

Die Krümmungsachse x' definiert eine Krümmung der torischen Reflexionsfläche 32 der Feldfacette 25 in der y'z'-Ebene (Vergleiche Fig. 7). Ein Krümmungsradius der Reflexionsfläche 32 in dieser y'z'-Ebene ist als Rₓ' bezeichnet.

Entsprechend definiert die Krümmungsachse y' eine Krümmung der Reflexionsfläche 32 in der x'z'-Ebene. Ein Krümmungsradius der Reflexionsfläche 32 in der x'z'-Ebene ist mit R_{y}' bezeichnet.

Die Fig. 6 und 7 zeigen die Krümmungsradien Rₓ', R_{y}' stark schematisch. Auch andere Krümmungsverhältnisse sind möglich. Sowohl Rₓ' als auch R_{y}' liegen im Bereich zwischen 200 mm und 2000 mm, beispielsweise im Bereich zwischen 500 mm und 1500 mm, im Bereich zwischen 800 mm und 1200 mm und insbesondere im Bereich von 1000 mm. Dabei gilt immer: Rₓ' ≠ R_{y}'. Eine Exzentrizität ΔR = Rₓ' - R_{y}' liegt im Bereich zwischen 10 mm und 200 mm, beispielsweise im Bereich zwischen 15 mm und 100 mm, zwischen 20 mm und 60 mm und insbesondere im Bereich um 40 mm. Für ΔR/ R_{y}' gilt ein Prozentbereich zwischen 0,5% und 10%, insbesondere zwischen 1% und 8%, zwischen 2% und 6%, beispielsweise im Bereich um 4%.

Zudem gilt, dass der kleinere der beiden Krümmungsradien Rₓ', R_{y}' der torischen Reflexionsfläche 32 endlich ist. Der andere der beiden Krümmungsradien R_{y}', Rₓ' kann unendlich sein, sodass eine zylindrische Reflexionsfläche 32 resultiert, oder kann endlich sein, sodass eine torische Reflexionsfläche 32 mit einer über zwei Krümmungsachsen gekrümmten Reflexionsfläche resultiert.

Eine zylindrische Fläche bzw. Zylinderfläche stellt einen Spezialfall einer torischen Fläche dar und ist ebenfalls eine torische Fläche im Sinne dieser Anmeldung.

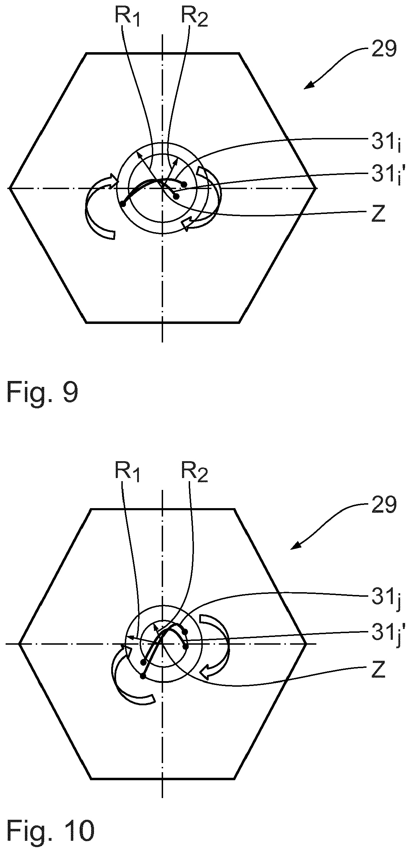

Anhand der Fig. 9 und 10 wird nachfolgend eine Wirkung einer torischen Reflexionsflächengestaltung der Ausricht-Feldfacetten 25 erläutert.

Die Fig. 9 und 10 zeigen eine weitere Variante einer Pupillenfacette 29, ausgeführt als hexagonal berandete Pupillenfacette.

Fig. 9 zeigt auf der Reflexionsfläche der dargestellten Pupillenfacette 29 den feldabhängigem Schwerpunktverlauf 31ᵢ, 31ᵢ' der Lichtquellenabbildung für einen Ausleuchtungskanal 16ᵢ. Diese beiden feldabhängigen Schwerpunktverläufe 31ᵢ, 31ᵢ' liegen auf derselben Pupillenfacette 29 vor und ergeben sich durch die abbildende Wirkung einerseits einer konventionellen, nicht verkippten Ausricht-Feldfacette 25 (Schwerpunktverlauf 31ᵢ) und andererseits durch eine erfindungsgemäß verkippte Ausricht-Feldfacette 25 (Schwerpunktverlauf 31ᵢ'). Diese beiden Schwerpunktverläufe 31ᵢ, 31ᵢ' sind in der Fig. 9 als schematische Überlagerung dargestellt, die sich aufgrund der Wirkung sowohl der konventionellen als auch der erfindungsgemäß verkippten Ausricht-Feldfacette 25 ergibt.

Aufgrund der Abbildung durch die konventionelle Ausricht-Feldfacette 25 ergibt sich ein Schwerpunktverlauf 31ᵢ mit einem maximalen Abstand R₁ von einem Zentrum Z der Reflexionsfläche des Pupillenfacettenspiegels 29. Dieser Abstandswert R₁ ist in der Fig. 9 als Radius eines Umkreises um das Zentrum Z beschrieben, in den der Schwerpunktverlauf 31ᵢ eingeschrieben ist. Die abbildende Wirkung der verkippten Ausricht-Feldfacette 25 resultiert in einem feldabhängigen Schwerpunktverlauf 31ᵢ', der um das Zentrum Z der Pupillenfacette 29 verkippt und gleichzeitig gestaucht ist. Aufgrund der sich durch die Verkippung ergebenden, geänderten Wirkung der Ausricht-Feldfacette 25 ergibt sich der Schwerpunktverlauf 31ᵢ' mit einem kleineren maximalen Abstand R₂ vom Zentrum Z der Reflexionsfläche des Pupillenfacettenspiegels 29. Die vorstehend erwähnte Stauchung des Schwerpunktverlaufs 31ᵢ' im Vergleich zum konventionellen Schwerpunktverlauf 31ᵢ bewirkt, dass sich der maximale Abstand R₂ des feldabhängigen Schwerpunktverlaufs 31ᵢ' im Vergleich zum Abstand R₁ um etwa 25% verringert hat. Es gilt also einerseits R₂ < R₁ und andererseits gilt etwa: R₂ = 0,75R₁.

Fig. 10 zeigt feldabhängige Schwerpunktverläufe 31ⱼ, 31ⱼ' eines Beleuchtungslicht-Bündels eines weiteren Ausleuchtungskanals 16ⱼ bei der Abbildung einerseits durch eine konventionelle und verkippte Feldfacette 25 und andererseits durch eine Ausricht-Feldfacette 25 mit torischer und um die Achsen-Kippwinkel α, β verkippter Reflexionsfläche 32. Es resultieren feldabhängige Schwerpunktverläufe 31ⱼ'. Der zur konventionellen Feldfacette 25 gehörende Schwerpunktverlauf ist mit 31ⱼ bezeichnet. Der zur verkippten Ausricht-Facette 25 gehörende Schwerpunktverlauf 31ⱼ' ist um das Zentrum Z der zugehörigen Pupillenfacette 29 ebenfalls verkippt und gleichzeitig gestaucht.

Auch beim Ausleuchtungskanal 16ⱼ nach Fig. 10 bewirkt die Stauchung, dass sich ein maximaler Abstand R₂ des feldabhängigen Schwerpunktverlaufs 31ⱼ' vom Zentrum Z der zugehörigen Pupillenfacette 29 im Vergleich zum Abstand R₁ verringert hat. Es gilt wiederum R₂ < R₁. In etwa gilt auch hier: R₂ = 0,75R₁.

Die Kippwinkel α, β betragen bei den in den Fig. 9 und 10 dargestellten Schwerpunktverläufen jeweils 6 Grad.

Insbesondere die Stauchung der Schwerpunktverläufe 31ᵢ', 31ⱼ' im Vergleich zu dem mit den konventionellen Feldfacetten geführten Beleuchtungslicht-Teilbündeln führt zu einer Einengung der Beleuchtungslicht-Teilbündel 16ᵢ, 16ⱼ auf den Pupillenfacetten 29, sodass eine vollständige Reflexion der Teilbündel 16ᵢ, 16ⱼ an den zugehörigen Pupillenfacetten 29 ohne unerwünschte Lichtverluste erleichtert ist. Drifts der Teilbündel 16ᵢ, 16ⱼ auf den Pupillenfacetten 29, können besser toleriert werden. Die Stauchung der Schwerpunkverläufe 31ᵢ', 31ⱼ' führt zudem dazu, dass ein mögliches Abschneideverhalten von Beleuchtungslicht-Subbündeln 16ᵢⁿ weniger feldabhängig wird und eine derartige Abhängigkeit auch am Feldrand und insbesondere jenseits der Feldränder am Ort der Anordnung möglicher Energie- bzw. Dosissensoren reduziert ist. Ein Nachregeln der Lichtquelle 2 als Reaktion auf gemessene Intensitätsänderungen ist somit vereinfacht.

Bei einer Ausführung des Feldfacettenspiegels 19 mit den Ausricht-Facetten sind die Kippwinkel α, β aller Ausricht-Facetten 25 gleich.

Bei einer alternativen Ausführung, die schematisch in der Fig. 6 dargestellt ist, sind die Ausricht-Kippwinkel α (und β) einerseits sowie α' (und entsprechend β') andererseits voneinander verschieden. Bei der Ausführung nach der Fig. 6 ist α', also der Winkel zwischen der Führungsachse x" der in der Figur 6 linken Feldfacette 25 und der Ausrichtkoordinate x, größer als der Winkel α zwischen der Krümmungsachse x' der in der Figur 6 rechten Feldfacette 25 und der Ausrichtkoordinate x.

Bei der Projektionsbelichtung mit Hilfe der Projektionsbelichtungsanlage 1 wird wenigstens ein Teil des Retikels 7 im Objektfeld 5 auf einen Bereich der lichtempfindlichen Schicht auf den Wafer 13 im Bildfeld 11 zur lithografischen Herstellung eines mikro- beziehungsweise nanostrukturierten Bauteils, insbesondere eines Halbleiterbauteils, beispielsweise eines Mikrochips, abgebildet. Hierbei werden das Retikel 7 und der Wafer 13 zeitlich synchronisiert in der y-Richtung kontinuierlich im Scannerbetrieb verfahren.

## Patentansprüche

1. Facettenspiegel (19) für die EUV-Projektionslithografie,
- mit einer Mehrzahl von Facetten (25) zur Reflexion von EUV-Beleuchtungslicht (16),
- wobei mindestens einige der Facetten (25) als Ausricht-Facetten ausgeführt sind und eine Reflexionsfläche (32) haben, deren Randkontur (33) längs zweier Ausrichtungskoordinaten (x, y) einer Facetten-Gesamtanordnung ausgerichtet ist,
- wobei die Reflexionsfläche (32) mindestens einer der Ausricht-Facetten (25) eine Flächenform hat, die unterschiedliche Krümmungen längs zweier Krümmungsachsen (x', y') aufweist, **dadurch gekennzeichnet, dass** diese Krümmungsachsen (x', y') gegenüber den Ausrichtungskoordinaten (x, y) der Facetten-Gesamtanordnung um einen endlichen Achsen-Kippwinkel (α, β) verkippt sind.

2. Facettenspiegel nach Anspruch 1, **dadurch gekennzeichnet, dass** die Reflexionsfläche von mindestens zweien der Ausrichtungs-Facetten (25) Flächenformen haben, die unterschiedliche Krümmungen längs zweier Krümmungsachsen (x', y') aufweisen, wobei sich die Achsen-Kippwinkel (α, α') dieser Ausrichtungs-Facetten unterscheiden.

3. Facettenspiegel nach Anspruch 1 oder 2, **dadurch gekennzeichnet, dass** der Achsen-Kippwinkel (α, β; α, β, α') mindestens ein Grad beträgt.

4. Facettenspiegel nach einem der Ansprüche 1 bis 3, **dadurch gekennzeichnet, dass** ein größerer Krümmungsradius (Rₓ'; R_{y}') der Reflexionsfläche (32) unendlich ist.

5. Facettenspiegel nach einem der Ansprüche 1 bis 3, **dadurch gekennzeichnet, dass** beide Krümmungsradien (Rₓ'; R_{y}') der Reflexionsfläche (32) endlich sind.

6. Beleuchtungsoptik (4) zur Beleuchtung eines Objektfeldes (5), in dem ein mit EUV-Beleuchtungslicht abzubildendes Objekt (7) anordendbar ist, mit Beleuchtungslicht (16),
- mit einem Facettenspiegel (19) nach einem der Ansprüche 1 bis 5.

7. Beleuchtungssystem (3) mit einer Beleuchtungsoptik (4) nach Anspruch 6 und mit einer Lichtquelle (2) zur Erzeugung des Beleuchtungslichts (16).

8. Optisches System mit einer Beleuchtungsoptik (4) nach Anspruch 6 und mit einer Projektionsoptik (10) zur Abbildung des Objektfeldes (5) in ein Bildfeld (11).

9. Projektionsbelichtungsanlage (1) mit einem optischen System nach Anspruch 8 und einer Lichtquelle (2) zur Erzeugung des Beleuchtungslichts (16),
- mit einem Objekthalter (8) mit einem Objektverlagerungsantrieb (9) zur Verlagerung des Objekts (7) längs einer Objektverlagerungsrichtung (y),
- mit einem Waferhalter (14) mit einem Waferverlagerungsantrieb (15) zur mit dem Objektverlagerungsantrieb (9) synchronisierten Verlagerung eines Wafers (13).

10. Verfahren zur Herstellung eines mikro- bzw. nanostrukturierten Bauteils mit folgenden Schritten:
- Bereitstellen einer Projektionsbelichtungsanlage (1) nach Anspruch 9,
- Bereitstellen eines Wafers (13),
- Bereitstellen einer Lithografiemaske (7),
- Projizieren wenigstens eines Teils der Lithografiemaske (7) auf einen Bereich einer lichtempfindlichen Schicht des Wafers (13) mit Hilfe der Projektionsoptik (10) der Projektionsbelichtungsanlage (1).

## Claims

1. Facet mirror (19) for EUV projection lithography,
- having a plurality of facets (25) for reflecting EUV illumination light (16),
- wherein at least some of the facets (25) are in the form of alignment facets and have a reflection surface (32), the edge contour (33) of which is aligned along two alignment coordinates (x, y) of an overall facet arrangement,
- wherein the reflection surface (32) of at least one of the alignment facets (25) has a surface shape that exhibits different curvatures along two axes of curvature (x', y'), **characterized in that** said axes of curvature (x', y') are tilted about a finite axis tilt angle (α, β) with respect to the alignment coordinates (x, y) of the overall facet arrangement.

2. Facet mirror according to Claim 1, **characterized in that** the reflection surface of at least two of the alignment facets (25) have surface shapes that exhibit different curvatures along two axes of curvature (x', y'), wherein the axis tilt angles (α, α') of these alignment facets differ.

3. Facet mirror according to Claim 1 or 2, **characterized in that** the axis tilt angle (α, β; α, β, α') is at least one degree.

4. Facet mirror according to one of Claims 1 to 3, **characterized in that** a greater radius of curvature (Rₓ'; R_{y}') of the reflection surface (32) is infinite.

5. Facet mirror according to one of Claims 1 to 3, **characterized in that** both radii of curvature (Rₓ'; R_{y}') of the reflection surface (32) are finite.

6. Illumination optical unit (4) for illuminating an object field (5), in which an object (7) that is to be imaged with EUV illumination light is arrangeable, with illumination light (16),
- having a facet mirror (19) according to one of Claims 1 to 5.

7. Illumination system (3) having an illumination optical unit (4) according to Claim 6 and having a light source (2) for generating the illumination light (16) .

8. Optical system having an illumination optical unit (4) according to Claim 6 and having a projection optical unit (10) for imaging the object field (5) into an image field (11).

9. Projection exposure apparatus (1) having an optical system according to Claim 8 and a light source (2) for generating the illumination light (16),
- having an object holder (8) with an object displacement drive (9) for displacing the object (7) along an object displacement direction (y),
- having a wafer holder (14) having a wafer displacement drive (15) for displacement of a wafer (13) in synchronization with the object displacement drive (9).

10. Method for producing a microstructured or nanostructured component, having the following steps:
- providing a projection exposure apparatus (1) according to Claim 9,
- providing a wafer (13),
- providing a lithography mask (7),
- projecting at least a portion of the lithography mask (7) onto a region of a light-sensitive layer of the wafer (13) using the projection optical unit (10) of the projection exposure apparatus (1) .

## Revendications

1. Miroir à facettes (19) pour la lithographie par projection EUV,
- comprenant une pluralité de facettes (25) destinées à la réflexion de lumière d'éclairage EUV (16),
- au moins certaines des facettes (25) étant réalisées sous la forme de facettes d'orientation et possédant une surface de réflexion (32) dont le profil de bordure (33) est orienté le long de deux coordonnées d'orientation (x, y) d'un arrangement global des facettes,
- la surface de réflexion (32) d'au moins l'une des facettes d'orientation (25) possédant une forme de surface qui présente des courbures différentes le long de deux axes de courbure (x', y'),
**caractérisé en ce que**
ces axes de courbure (x', y') étant inclinés d'un angle d'inclinaison d'axe (α, β) fini par rapport aux coordonnées d'orientation (x, y) de l'arrangement global des facettes.

2. Miroir à facettes selon la revendication 1, **caractérisé en ce que** la surface de réflexion d'au moins deux des facettes d'orientation (25) possède une forme de surface qui présente des courbures différentes le long de deux axes de courbure (x', y'), les angles d'inclinaison d'axe (α, α') de ces facettes d'orientation étant différents.

3. Miroir à facettes selon la revendication 1 ou 2, **caractérisé en ce que** l'angle d'inclinaison d'axe ((α, β ; (α, β, α') est égal à au moins un degré.

4. Miroir à facettes selon l'une des revendications 1 à 3, **caractérisé en ce qu'**un plus grand rayon de courbure (Rₓ', R_{y}') de la surface de réflexion (32) est infini.

5. Miroir à facettes selon l'une des revendications 1 à 3, **caractérisé en ce que** les deux rayons de courbure (Rₓ', R_{y}') de la surface de réflexion (32) sont infinis.

6. Optique d'éclairage (4) destinée à éclairer, avec de la lumière d'éclairage (16), un champ d'objet (5) dans lequel peut être disposé un objet (7) à représenter avec de la lumière d'éclairage EUV,
- comprenant un miroir à facettes selon l'une des revendications 1 à 5.

7. Système d'éclairage (3) comprenant une optique d'éclairage (4) selon la revendication 6 et comprenant une source de lumière (2) destinée à générer la lumière d'éclairage (16).

8. Système optique comprenant une optique d'éclairage (4) selon la revendication 6 et comprenant une optique de projection (10) destinée à représenter le champ d'objet (5) dans un champ d'image (11).

9. Équipement d'exposition par projection (1) comprenant un système optique selon la revendication 8 et une source de lumière (2) destinée à générer la lumière d'éclairage (16),
- comprenant un porte-objet (8) pourvu d'un mécanisme d'entraînement de déplacement d'objet (9) destiné à déplacer l'objet (7) le long d'une direction de déplacement d'objet (y),
- comprenant un porte-galette (14) pourvu d'un mécanisme d'entraînement de déplacement de galette (15) destiné à déplacer une galette (13) de manière synchronisée avec le mécanisme d'entraînement de déplacement d'objet (9).

10. Procédé de fabrication d'un élément structural micro- ou nanostructuré, comprenant les étapes suivantes :
- fourniture d'un équipement d'exposition par projection (1) selon la revendication 9,
- fourniture d'une galette (13),
- fourniture d'un masque de lithographie (7),
- projection d'au moins une partie du masque de lithographie (7) sur une zone d'une couche photosensible de la galette (13) à l'aide de l'optique de projection (10) de l'équipement d'exposition par projection (1).
